(19) **Europäisches Patentamt**

**European Patent Office**

**Office européen des brevets**

(11) **EP 1 726 966 A1**

(12) **EUROPEAN PATENT APPLICATION**

(43) Date of publication:
29.11.2006 Bulletin 2006/48

(51) Int Cl.:
*G01R 13/34* (2006.01)  *G01R 13/02* (2006.01)
*H03M 1/12* (2006.01)

(21) Application number: 06252682.7

(22) Date of filing: 23.05.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 24.05.2005 US 684565 P
09.02.2006 US 351722

(71) Applicant: **TEKTRONIX, INC.**
**Beaverton, OR 97077-0001 (US)**

(72) Inventor: **Tan, Kan**
**Beaverton, Oregon 97007 (US)**

(74) Representative: **Burke, Steven David et al**
**R.G.C. Jenkins & Co.**
**26 Caxton Street**
**London SW1H 0RJ (GB)**

(54) **Method and apparatus for reconstructing signals from sub-band signals**

(57) An acquisition apparatus for a test and measurement instrument includes an input to receive an input signal, a splitter to split the input signal into split signals, frequency shifters to frequency shift a sub-band of an associated split signal to within a digitizing bandwidth, digitizers to digitize one of the frequency shifted split signals or one of the split signals, digital frequency shifters to frequency shift an associated digitized frequency shifted split signal into a digitized split signal, filters to filter an associated digitized split signal, and a combiner to combine the filtered digitized split signals into a recombined signal, wherein each sub-band overlaps at least one other sub-band.

FIG. 2

**Description**

CROSS-REFERENCE TO RELATED APPLICATIONS

This application claims priority under 35 U.S.C. § 119(e) from U.S. Provisional Application serial number 60/684,565, filed on May 24, 2005, the contents of which are herein incorporated by reference in their entirety.

FIELD OF THE INVENTION

This invention relates to test and measurement instruments and, more particularly, to test and measurement instruments for reconstructing signals from sub-band signals of an input signal.

BACKGROUND

Digital oscilloscopes have limited input bandwidths. The bandwidth of an input signal is limited to the input bandwidth of the oscilloscope. In U.S. Patent Application Publication 2004/0128076 to Pupalaikis, et al., a real-time oscilloscope is disclosed with an increased usable bandwidth. The real-time oscilloscope splits the input signal into multiple split signals. One split signal is digitized. Simultaneously, the other split signals are frequency shifted to a baseband frequency range and digitized. The digitized frequency-shifted signals are frequency shifted to their original frequency range and then combined with the other digitized signals to create a representation of the input signal. By frequency shifting sub-bands of the input signal to be within the bandwidth of their respective digitizers, an input signal having a frequency range larger than the input bandwidth of a digitizer may be acquired using the lower bandwidth digitizers.

However, in a transition band between adjacent sub-bands the channel characteristics deviate from ideal. The magnitude response is no longer flat and phase response is no longer linear, distorting the signal in that transition band. As a result, it is difficult to combine the split signals and get smooth overall system response.

Accordingly a need remains for an improved method and apparatus for reconstructing signals from sub-band signals.

SUMMARY

An acquisition apparatus for a test and measurement instrument includes an input to receive an input signal, a splitter to split the input signal into split signals, frequency shifters to frequency shift a sub-band of an associated split signal to within a digitizing bandwidth, digitizers to digitize one of the frequency-shifted split signals or one of the split signals, digital frequency shifters to frequency shift an associated digitized frequency-shifted split signal into a digitized split signal, filters to filter an associated digitized split signal, and a combiner to combine the filtered digitized split signals into a recombined signal, wherein each sub-band overlaps at least one other sub-band.

Another aspect of the invention includes a method of reconstructing a signal including receiving an input signal having sub-bands, frequency shifting at least one sub-band, digitizing the sub-bands, digitally frequency shifting the at least one frequency-shifted sub-band to the sub-band's original frequency range, filtering the sub-bands, and recombining the sub-bands, wherein a pass-band of at least one of the sub-bands overlaps a pass-band of another sub-band.

The foregoing and other objects, features, and advantages of the invention will become more readily apparent from the following detailed description of preferred embodiments which proceed with reference to the accompanying drawings.

BRIEF DESCRIPTION OF THE DRAWINGS

FIG. 1 is a block diagram of an embodiment of an acquisition apparatus for a test and measurement instrument according to the invention.

FIG. 2 illustrates an example of sub-bands of an input signal as used in the apparatus in FIG. 1, in which alternating sub-bands are indicated by alternating solid and dashed lines.

FIG. 3 illustrates an example of filters for two adjacent sub-bands and the combination of the filters as used in the apparatus in FIG. 1.

FIG. 4 is a graph of an impulse response of examples of raised cosine filters as used in the apparatus in FIG. 1.

FIG. 5 illustrates the frequency response of a raised cosine filter with different $\alpha$ factors as used in the apparatus in FIG. 1.

FIG. 6 is a block diagram of another embodiment of an acquisition apparatus according to the invention.

FIG. 7 is a flowchart of an embodiment of a method of reconstructing a signal according to the invention.

FIG. 8 is a flowchart of another embodiment of a method of reconstructing a signal according to the invention.

FIG. 9 is a flowchart of another embodiment of a method of reconstructing a signal according to the invention including calibration of time delays.

DETAILED DESCRIPTION

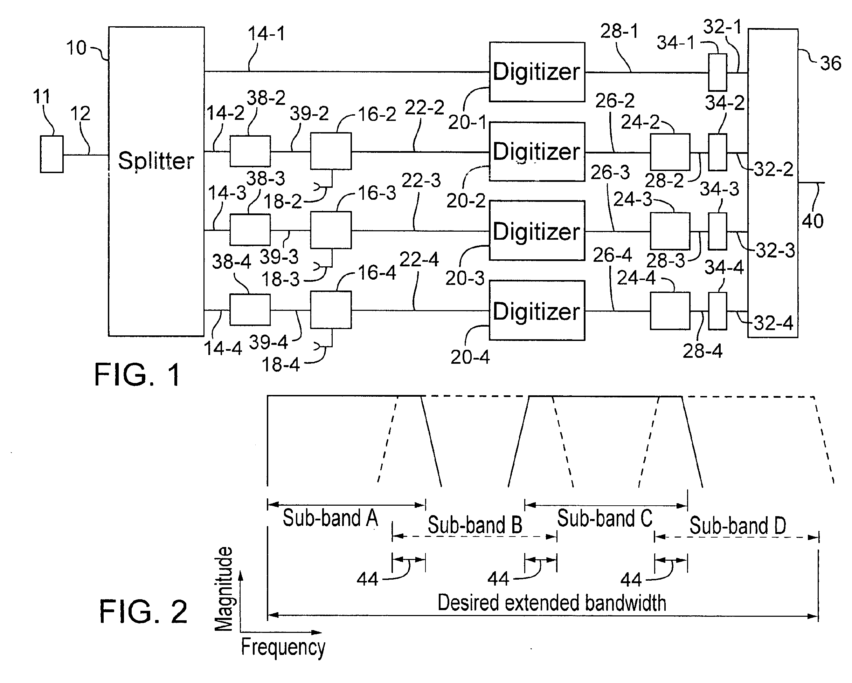

As shown in FIG. 2 of Pupalaikis, frequency bands A and B abut one another without any overlap. Filtering the frequency bands A and B to create the abrupt transition from frequency band A to frequency band B in a combined signal requires filters having sharp rolloffs in their amplitude responses. In general, such filters have phase distortion near the edge of the passband. Furthermore, the edge of the passband and the quality of the distortion may change as a function of time and the environment. As a result, even if any distorted frequency responses are removed through calibration, time and environmental changes may make the calibration invalid.

To overcome these deficiencies, overlapping sub-bands as shown in FIG. 2 of this disclosure are used in place of the abutting frequency bands of Pupalaikis. Because of the overlap, when combining sub-bands into a combined signal, two sources are available for the frequency components of the combined signal that are within the overlap of two sub-bands. As described above, the frequency response at the edge of a band may be distorted. With the overlap, the edge of one sub-band is well within the other sub-band where that sub-band is not distorted. Appropriate filtering blends the two overlapping sub-bands into the combined signal, using the least distorted frequency components of the two. As a result, an improved combined signal may be obtained.

This disclosure describes a method and apparatus to achieve an accurate reconstruction of an input signal by overlapping the flat passbands of test and measurement instrument channels. In the flat passband, the magnitude response is flat and the phase response is linear. By applying properly synthesized filters, the transition band and any associated distortion outside of the flat passband will have a substantially reduced effect on the signal reconstruction. The overlapping method and apparatus sacrifices the total extended bandwidth of the system to improve the flatness of the magnitude response and the linearity of the phase response of the system. As a result, the fidelity of acquired signals is improved.

FIG. 1 illustrates an acquisition apparatus for a test and measurement instrument. The acquisition apparatus includes an input 11 to receive an input signal 12. A splitter 10 splits the input signal 12 into multiple split signals 14. For the split signals 14 and subsequent elements that affect the split signals 14, a suffix such as -1 or -2 has been added to distinguish the elements affecting one split signal 14, such as 14-1, from elements affecting another split signal 14, such as 14-2. Although the elements and signals will be described commonly, one of ordinary skill in the art will understand that elements described with a suffix may be either the same or different from one another, depending on the specifications of the acquisition apparatus.

Frequency shifters 16 frequency shift a sub-band of the input signal 12 in an associated split signal 14 to within a digitizing bandwidth. Each of the sub-bands overlaps at least one other sub-band.

Digitizers 20 digitize the frequency-shifted split signals 22 and any split signals 14 that are not frequency shifted. Digital frequency shifters 24 frequency shift associated digitized frequency-shifted split signals 26 into digitized split signals 28. The split signal 14 that was not frequency shifted is digitized by a digitizer 20 into a digitized split signal 28. The digitized frequency-shifted split signals 26 are referred to as digitized split signals 28 after the frequency shifting from the digital frequency shifters 24 because the digitized frequency-shifted split signals 26 are frequency shifted back to their original frequency range.

Filters 34 filter the digitized split signals 28. A combiner 36 combines the filtered digitized split signals 32 into a recombined signal 40.

A sub-band is a designation of a frequency range. A sub-band of a signal is that signal over the frequency range of the sub-band. If a particular signal is referred to as having a sub-band, or a sub-band is referred to as on the signal, that signal has at least the frequency components from the original signal that were within the sub-band. The signal may have other frequency components from the original signal. The inclusion or exclusion of frequency components outside of the sub-band does not change the relationship of the signal and the sub-band. The signal still has the sub-band.

FIG. 2 illustrates an example of the sub-bands as described above, in which alternating sub-bands are indicated by alternating solid and dashed lines. Sub-Band A begins at 0Hz and extends beyond the beginning of Sub-band B. As a result, there is an overlap between Sub-band A and Sub-Band B. Similarly, Sub-band B extends beyond the beginning of Sub-band C, overlapping Sub-band C. Sub-band C is similar to Sub-band B, overlapping two adjacent sub-bands, Sub-band B and Sub-band D. Sub-band D overlaps Sub-band C. These sub-bands make up the desired extended bandwidth of the acquisition apparatus. A signal with frequencies within any of these sub-bands may be accurately acquired.

Although four sub-bands, Sub-bands A-D, are illustrated in FIG. 2, any number of sub-bands may be used. For example, two sub-bands may be used. Alternatively, eight sub-bands may be used.

A frequency in the frequency range where a first and a second sub-band overlap will be part of both a signal having the first sub-band and a signal having the second sub-band. For example, a frequency in the overlap region 44 of Sub-band A and Sub-band B will be part of both a signal having Sub-band A and a signal having Sub-band B. Thus, frequencies in the overlap regions 44 are duplicated in both sub-bands. This redundancy provides useful information to help achieve an accurate signal reconstruction.

The sub-bands need not be associated with any particular component. However, the choice of sub-bands may be influenced by the components used. For example, a digitizer 20 may have a bandwidth from 0 to 10 GHz. Sub-bands with widths of 10 GHz may be chosen to utilize as much of the bandwidth of the digitizer 20 as possible. However, a sub-band is not limited to the bandwidth of any component. For example, a sub-band may be chosen with a more narrow width than the bandwidth of any given component to provide extra margin.

Referring to FIG. 1, the splitter 10 splits the input signal 12 into the split signals 14. One sub-band is associated with one split signal 14. As a result of any overlapping sub-bands, the splitter 10 provides frequency components within the overlap to the split signals 14 that are associated with the overlapping sub-bands. Thus, a single frequency, particularly a frequency within an overlap of adjacent sub-bands, may be part of two split signals 14.

As described above, a signal may contain more than the frequency components within a sub-band. In fact, a split signal 14 may contain the frequency of all of the sub-bands. This can be accomplished by using a resistive power splitter for a splitter. A resistive power splitter generally splits an input signal into multiple signals having similar bandwidths. Thus, with a resistive divider having a bandwidth sufficient to cover the input signal 12, all of the split signals 14 will have similar frequency components. Thus, a split signal 14 may contain all of the sub-bands, yet be associated with only one sub-band.

Alternatively, the splitter 10 can include some signal shaping. As a result, a split signal 14 may include only frequency components of the input signal 12 that are within the sub-band associated with the split signal 14. Furthermore, a split signal 14 may include frequency components of its associated sub-band and any combination of the frequency components of other sub-bands or parts of the other sub-bands.

Each sub-band is frequency shifted by an associated frequency shifter 16. The frequency shifter 16 shifts the frequencies of the sub-band to be within a digitizing bandwidth by a frequency shift signal 18. For example, if a digitizer 20 has a bandwidth of 10 GHz, and a sub-band has a frequency range from 8 to 18 GHz, the sub-band frequencies are shifted down 8 GHz to a 0 to 10 GHz range. Similarly, another sub-band with a 16 to 26 GHz frequency range would be frequency shifted to the 0 to 10 GHz frequency range. Thus, a sub-band with-frequencies outside of the bandwidth of a digitizer 20 can still be digitized by the digitizer 20.

The frequency shifter 16 may be a mixer. The mixer may have a sinusoidal signal as a frequency shift signal 18. By mixing a split signal 14 with the sinusoidal signal in the mixer, the split signal 14 will be frequency shifted down by the frequency of the sinusoidal signal. For example, a sub-band having a frequency range from 10 to 15 GHz may be mixed with a sinusoidal signal with a frequency of 10 GHz. As a result, the 10 to 15 GHz frequency range may be shifted to a 0 to 5 GHz frequency range.

The selection of a mixing frequency F in Pupalaikis has been shown as the frequency that divides two frequency bands. Thus, the mixing frequency F is at the edge of both of the adjacent frequency bands. In contrast, with the sub-bands having an overlap, a different frequency is used. The overlap extends the edge of the sub-band from the former frequency dividing the frequency bands. The frequencies may be different by the width $\Delta f$ of the overlap region 44, or some fraction thereof. Thus, the frequency shift signal 18 can have a frequency of $F - \Delta f$. In another example, the frequency shift signal 18 can have a frequency of $F - \Delta f/2$. Furthermore, even if the frequency shift signal 18 is at the edge of one sub-band, it will not be at the edge of the adjacent sub-band.

The frequency shifter 16 may also include a prefilter 38. When using a mixer to frequency shift, frequency components on both sides of the frequency of the sinusoidal signal will be frequency shifted to a frequency range beginning at 0 Hz. Since only a frequency range on one side of the sinusoidal signal frequency is desired, a prefilter 38 may be used to filter out the frequencies in the frequency range on the other side of the sinusoidal signal frequency. Such a prefilter 38 may not be required if the split signal 14 to be mixed does not have undesired frequency components. For example, the splitter 10 may split the input signal 12 into sub-bands, with each split signal 14 having only the frequency components of its associated sub-band.

In addition, all of the frequency components on a split signal 14 outside of the associated sub-band need not be filtered by the prefilter, only the frequency components that may overlap with the sub-band after mixing. For example, with a sub-band frequency range of 10 to 15 GHz frequency shifted to 0 to 5 GHz, frequencies greater than 15 GHz and less than 5 GHz need not be filtered. Such frequencies will be frequency shifted to frequencies greater than 5 GHz, outside of the frequency-shifted frequency range of the sub-band.

Digitizers 20 digitize the signal input to the digitizer. In FIG. 1, this signal may be a split signal 14 or a frequency-shifted split signal 22. Digital frequency shifters 24 frequency shift an associated digitized frequency-shifted split signal 26 into a digitized split signal 28. The digital frequency shifters 24 frequency shift the digitized frequency-shifted split signal 26 back to its original frequency range. Since the split signals 14 contained the sub-bands of the input signal 12, the aggregate of the digitized split signals 28 represent digitized versions of the sub-bands of the input signal 12.

However, the digitized split signals 28 may be distorted because magnitude and phase distortion of components on the path associated with the sub-bands. Filters 34 filter associated digitized split signals 28. In general, the filters shape the digitized split signals 28 to reduce the effects of any distortion. The filters of adjacent sub-bands work in combination to generate a less distorted signal after the combiner 36.

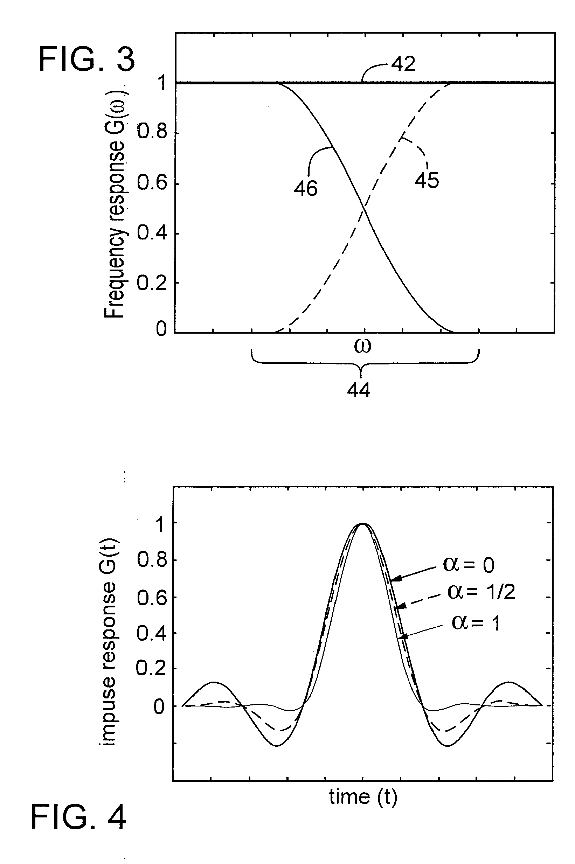

FIG. 3 illustrates filters of two adjacent sub-bands and the combination of the filters. A lower filter frequency response 46 transitions from a gain of one to a gain of zero in the overlapping frequency range 44. Similarly, the upper filter frequency response 45 transitions from a gain of zero to a gain of one in the overlapping frequency range 44. The magnitude 42 of the sum of the lower filter frequency response 46 and the upper filter frequency response 45 is one across the overlapping frequency range region 44.

As described above, both sub-bands associated with an overlapping frequency range 44 have frequency components of the input signal 12 from the overlapping frequency range 44. However, the frequency components may be more distorted closer to the edge of a sub-band. Because of the transitions of the filters in the overlapping frequency range 44, as a frequency component transitions from a lower frequency to a higher frequency, the source for that frequency component in a recombined signal 40 transitions from signals having the lower sub-band to the signals having the higher sub-band.

As the frequency component transitions to a higher frequency, the contribution from the lower sub-band decreases because of the decreasing frequency response of the lower filter frequency response 46. In contrast, the contribution from the higher sub-band increases because of the increasing frequency response of the higher filter frequency response 45. Since the sum 42 of the frequency responses is one, in a recombined signal 40, a frequency component in the overlap region 44 retains the same amplitude as it had in the input signal 12, but the source of the contribution changes from one sub-band to another.

A combiner 36 combines the filtered digitized split signals 32 into a recombined signal 40. The combiner 36 may be a digital summing block summing the filtered digitized split signals 32 into the recombined signal 40. As described above, a filtered digitized split signal 32 has frequency components from across the associated sub-band. However, the relative amplitude of the frequency components begins to decrease at the edge of overlap region 44 and diminishes to zero at the edge of the sub-band. Thus, as a frequency approaches the edge of a sub-band, the contribution of that frequency from the sub-band is reduced. Thus, the duplicate frequency components in adjacent sub-bands are blended together, weighing the less distorted frequency components of one sub-band higher than those of the adjacent sub-band.

In general, the frequency response of a filter 34 should satisfy the following equation, equation 1

$$H_n(\omega)G_n(\omega) + H_{n+1}(\omega)G_{n+1}(\omega) = 1 \qquad\qquad (1)$$

where $H_n(\omega)$ is the frequency response affecting an $n^{th}$ sub-band, $H_{n+1}(\omega)$ is the frequency response affecting an $n+1^{th}$ sub-band, $G_n(\omega)$ is the frequency response of the filter 34 for the $n^{th}$ sub-band, and $G_{n+1}(\omega)$ is the frequency response of the filter for the $n+1^{th}$ sub-band.

The filters 34 may be raised cosine filters. An explanation of raised cosine filters may be found in "Introduction to communication systems" by Ferrel Stremler, published by Addison Wesley, in 1992. A raised cosine filter may have a transfer function as defined in equation 2:

$$X(\omega) = \begin{cases} 1 & 0 \le |\omega| \le (1-\alpha)W \\ 0.5\{1 - \sin[\dfrac{\pi}{2\alpha W}(|\omega| - W)]\} & (1-\alpha)W \le |\omega| \le (1+\alpha)W \\ 0 & |\omega| > (1+\alpha)W \end{cases} \qquad (2)$$

where W is a cutoff frequency, and $\alpha$ is a roll-off factor. Although $X(\omega)$ as a raised cosine filter has been described as centered at a frequency of 0, one of ordinary skill in the art will understand that the filter may be offset from 0 to any desired frequency. For example, a raised cosine filter may be centered at the center frequency of a sub-band.

Raised cosine filters, when used as filters 34 satisfy the above described blending of the adjacent sub-bands. That is, if adjacent sub-bands use raised cosine filters having equal $\alpha$ and W values, yet are offset such that the filters 34 cross at a magnitude of 0.5, the sum of the filters 34 will be one in the overlapping region.

When filtering a sub-band with a raised cosine filter, the bandwidth of the raised cosine filter where the response is not zero should be within a flat passband of the frequency response of the sub-band. As a result, a transition band of the sub-band, where there is magnitude and phase distortion, is filtered with a gain of zero. In one example, the frequency response of the sub-band in the flat passband is assumed to be one. Since the frequency response of the sub-band is one within the frequency range where the filter 34 has a non-zero gain, and the sum of the filters is one, the system has a frequency response of one, satisfying the above equation. As a result, there is no magnitude or phase distortion.

FIG. 4 is a graph of an impulse response of examples of raised cosine filters. Note that the impulse response converges to zero in both ends. Techniques such as windowing can be applied to the impulse response in order to get a finite impulse response (FIR) filter with certam number of taps for implementation.

The cutoff frequency W and the roll-off factor $\alpha$ of a raised cosine filter may be varied as desired. As $\alpha$ decreases, the overlap with the adjacent sub-bands decreases. As a result the possible overall bandwidth of the acquisition apparatus increases. However, the number of taps for implementing the raised cosine filter increases as $\alpha$ decreases. Thus, for lower $\alpha$, a longer filter would be needed. If the overlap becomes too narrow, the required length of the filter makes it too difficult to implement. In contrast, as $\alpha$ increases, the number of taps for a raised cosine filter decreases. However, the overall bandwidth of the acquisition apparatus decreases because of the increased overlap. The cutoff frequency W and the roll-off factor $\alpha$ may be designed to achieve a desired compromise between these factors.

One method of selecting the W and $\alpha$ factors for the filter 34 is as follows. For a given flat passband of a digitizer $F_{flat}$ and a selected overlap bandwidth of $F_{overlap}$, the W and $\alpha$ factors are determined by the following equations, equations 3 and 4:

$$W = \left(F_{flat} - F_{overlap}\right)/2 \qquad (3)$$

$$\alpha = F_{overlap}/(2 \times W) \qquad (4)$$

For the filters 34 associated with different sub-bands, the center frequency of the filter 34 may be adjusted accordingly. The filter 34 for an unshifted digitized split signal 28 would be adjusted to be a low pass filter using different W and $\alpha$ factors accordingly. For example, the W for the low pass filter may be 2 times the W specified in (3), $\alpha$ may be 0.5 times the $\alpha$ specified in (4). As a result, the product of $\alpha$ and W is the same for the low pass filter as it is for the other filters 34 of the apparatus. It is observed from (2) that the transition band is determined by $2\alpha W$. The filter of the highest sub-band may be adjusted to be a high pass filter accordingly, where W and $\alpha$ factors may need to be adjusted.

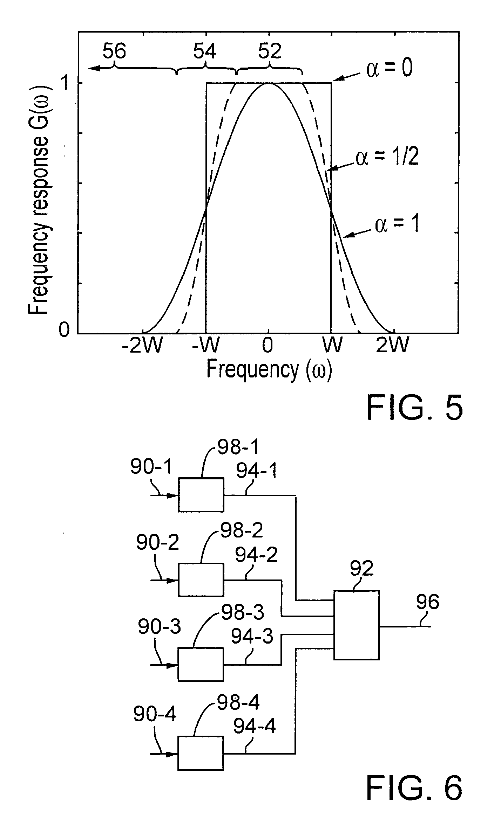

FIG. 5 illustrates the frequency responses of raised cosine filters with different $\alpha$ factors. As shown for an $\alpha$ factor of 0.5, the filter frequency response has a passband 52, an attenuation band 56, and a transition band 54. The passband 52 is where the frequency response of the filter is one. The attenuation band 56 is where the frequency response of the filter is zero. The transition band 54 is where the frequency response changes from one to zero according to a raised cosine function.

The passband 52 of a filter 34 for an associated sub-band is a frequency range where there is no overlap of the sub-band with a frequency range of and adjacent sub-band. For example, consider a first sub-band with a frequency range of 0 to 6 GHz, a second sub-band with a frequency range of 5 to 11 GHz, and a third sub-band with a frequency range of 10 to 16 GHz. The passband 52 of a filter 34 for the second sub-band would be 6 to 10 GHz, where there is no overlap with a frequency range of the other sub-bands.

The transition band 54 extends between the passband 52 and a passband 52 of a filter 34 for an adjacent sub-band. The transition band 54 may have a raised cosine response. In the example above, the passband 52 of a filter 34 for the third sub-band would begin at 11 GHz. Thus, a transition band 54 of the filter for the second sub-band would begin at 10 GHz, the end of the passband 54 of the filter 34 for the second sub-band, and end at 11 GHz, the beginning of the passband of the filter 34 for the third sub-band.

In other words, the transition band 54 is the frequency range over which the frequency ranges of adjacent sub-bands overlap. Since a sub-band may be adjacent to more than one sub-band, the filter 34 for that sub-band may have more than one transition band 54. The additional transition bands 54 would complement the filter 34 of the other sub-band. For example, the filter 34 for the second sub-band from above would have a second transition band 54 from 5 to 6 GHz, the overlap region 44 of the frequency ranges of the first and second sub-bands.

The attenuation band 56 is any frequency range outside of the passband 52 and any transition bands 54. There may be more than one attenuation band 56, depending on the frequency range of the sub-band. In the example above, the filter 34 for the second sub-band would have a first attenuation band from 0 to 5 GHz, and a second attenuation band from 11 GHz and higher.

Although filters 34 have been described having equivalent frequency responses although frequency shifted according to the associated sub-band, and sub-bands have been described as having equal width frequency ranges, a width of a frequency range of a sub-band may be different from a width of the frequency range of another sub-band. As a result, the frequency responses of sub-bands would no longer be frequency shifted duplicates. However, the frequency responses of filters 34 of overlapping sub-bands would still need complementary shapes summing to a constant such as one within the overlap frequency range to satisfy equation 1 above.

The filter 34 may optionally compensate for non-ideal frequency responses in acquisition apparatus. For a frequency-shifted sub-band, the input signal 12 will pass through a splitter 10, a frequency shifter 16, a digitizer 20, a digital frequency shifter 24, and a combiner 40. Each of these components and any other additional components may not have an ideal response of one. The aggregate of the frequency responses of the components affecting a sub-band may be compensated by modifying the frequency response of the filter 34 for that sub-band.

Referring to FIG. 1, as described above, the frequency-shifted signals 22 are frequency shifted back to their original frequencies into digitized split signals 28 by digital frequency shifters 24. Such a digital frequency shifter 24 may be implemented as a multiplier multiplying or mixing a digitized frequency-shifted signal 26 by a sinusoidal signal with a frequency the same as the frequency shift signal 18 for the sub-band. However, such multiplication may generate both the desired frequency-shifted signal and an image of that signal. An image reject filter may be needed to remove the image generated by the multiplication. However, if a filter 34 as described above is used to filter the digitized split signal, 28, no image reject filter is needed. The image would fall within the attenuation band of the filter 34. Because the gain for the attenuation band is zero, the image will be removed by the filter 34. Thus, no image reject filter is needed.

FIG. 6 is a block diagram of another embodiment of an acquisition apparatus according to the invention. The acquisition apparatus includes filters 98 and a combiner 92. Each filter 98 filters one of the sub-band signals 90 of an input signal. At least one of the sub-bands of the sub-band signals 90 overlaps an adjacent sub-band of another sub-band signal 90. The combiner 92 combines the filtered sub-band signals 94 into a recombined signal 96.

The sub-band signals 90 are signals that have at least the frequency components of the input signal that are within the associated sub-band. As described above, other frequency components, even other sub-bands, may be present in any one sub-band signal 90. The filter 98 will filter out any frequency components not in the sub-band, shaping the sub-band signal 90.

The filter 98 may have the same characteristics as a filter 34 described above. As a result, the filter 98 will prepare the sub-band signals 90 for combination in the combiner 92.

The combiner 92 may be the combiner 36 as described above. However, the combiner 92 may additionally include digital frequency shifters similar to the digital frequency shifters 24 described above. With digital frequency shifters, the sub-band signals 90 may be the representation of the sub-bands frequency shifted to be within the bandwidth of a digitizer. The sub-band signals 90 are filtered with filters 98 having frequency responses that, when shifted back to the original frequencies of the sub-band, satisfy equation (1) above.

Although frequency responses and sums have been described as having a value of one, a person of ordinary skill in the art will understand that such frequency responses and sums may be a constant other than one. For example, if extra gain is desired, the constant for a frequency response may be two. Furthermore, the constant is not limited to a real number. The constant may be a complex number with an imaginary component. As such, a complex constant may impart a phase shift to signals affected by the complex constant.

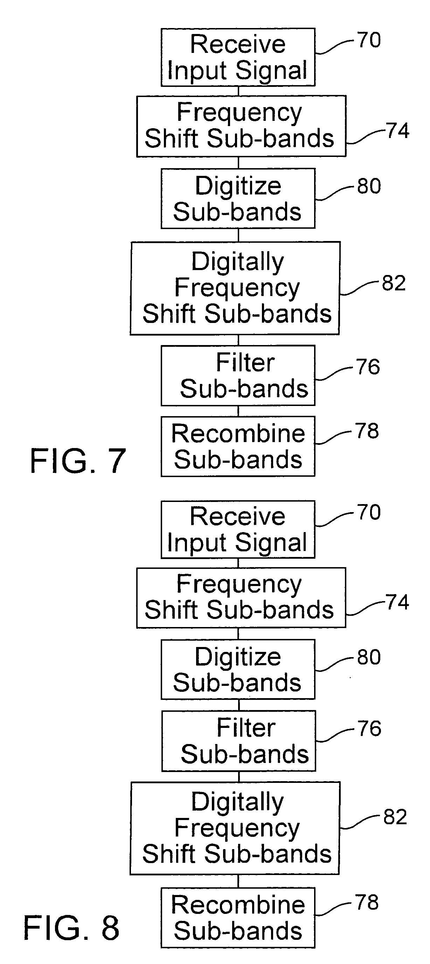

FIG. 7 is a flowchart of a method of reconstructing a signal. An input signal having multiple sub-bands is received in 70. At least one of the sub-bands is frequency shifted in 74. The sub-bands are digitized in 80, and digitally frequency shifted in 82. The sub-bands are filtered in 76. The filtered sub-bands are recombined in 78.

The sub-bands of the input signal received in 70 does not limit the input signal to any particular type of signal. Rather, as described above, the sub-bands are a way of characterizing the input signal. Any input signal may be described with reference to sub-bands. The sub-bands identify frequency bands or ranges of the input signal that are subsequently manipulated. Furthermore, a signal referred to as having a sub-band may include other frequencies outside of the sub band, although the sub-band itself would be a portion of the frequency components of that signal.

The sub-bands cover a desired frequency range. Each sub-band identifies a range of frequency components of the input signal. At least one of these sub-bands overlaps with another sub-band.

At least one sub-band is frequency shifted in 74. The sub-bands that have frequency components outside of the bandwidth of a digitizer are frequency shifted to be within the bandwidth of the digitizer.

The sub-bands are digitized in 80. The sub-bands digitized in 80 include unshifted sub-bands and frequency-shifted sub-bands. Any frequency-shifted sub-bands are frequency shifted back to their original frequency in 82.

The sub-bands are frequency shifted back to their original frequency range in 82. As a result, frequencies beyond the bandwidth of the digitizer have been acquired. For example, if a digitizing bandwidth is 10 GHz, an 18 GHz signal may be frequency shifted to a 3 GHz signal and digitized. The digitized 3 GHz signal is frequency shifted back to 18 GHz digitally.

The sub-bands are filtered in 76. The filtering of the sub-bands weights the frequency components of the sub-bands. Frequency components of a sub-band outside of any overlap frequency range of sub-bands are passed through the filter. These frequency components are the main contributions to a recombined signal in that frequency range. Within an overlap frequency range, the contribution of frequency components transitions from one sub-band to another sub-band. For example, with overlapping sub-bands, one from 5 to 10 GHz and another from 9 to 14 GHz, the contribution from the sub-bands transitions from one to the other in the overlap frequency range of 9 to 10 GHz. At 9 GHz, the contribution from the sub-bands to the recombined signal comes solely from the 5 to 10 GHz sub-band. At 10 GHz, the contribution comes solely from the 9 to 14 GHz sub-band. Between 9 and 10 GHz, the amount that the 5 to 10 GHz sub-band contributes decreases and the amount that the 9 to 14 GHz sub-band contributes increases.

As described above, the filtering of sub-bands 76 may be after the digital frequency shifting 82 of the frequency-shifted sub-bands back to their original frequency. However, the filtering of sub-bands 76 may be at any point after the sub-bands are isolated from each other.

FIG. 8 is a flowchart of another embodiment of a method of reconstructing a signal according to the invention. The filtering in 76 may be after the sub-band is frequency shifted in 74 to be within the bandwidth of a digitizer. If the width of the frequency range of the sub-bands and the overlap of adjacent sub-bands is the same for all sub-bands, the frequency-shifted sub-bands may be filtered with the same filter prior to any digital frequency shifting in. 82. One exception is that the unshifted sub-band may be filtered with a similar filter without a second transition band near 0 Hz. Another exception is for the last sub-band. Because the last sub-band does not overlap any sub-bands with higher frequencies, the last sub-band may not have a second transition band at higher frequencies. For example, with sub-bands in 0 to 5 GHz, 4 to 9 GHz, and 8 to 13 GHz, a filter with a passband from 1 to 4 GHz may be used. The 4 to 9 GHz and 8 to 13 GHz sub-bands are frequency shifted to the 0 to 5 GHz range. A filter with a transition band from 4 to 5 GHz is applied to the 0 to 5 GHz sub-band and the 4 to 9 GHz sub-band. A filter with a transition band from 0 to 1 GHz is applied to the 4 to 9 GHz sub-band and the 8 to 13 GHz sub-band. Thus, the sub-band from 0 to 5 GHz was not filtered with a filter having a transition band from 0 to 1 GHz. If using a raised cosine filter described above, the filter for the sub-band from 0 to 5 GHz can choose factors W to be 4.5 GHz and $\alpha$ to be 0.111. The filter for the sub-band from 4 to 9 GHz can choose factors W to be 2 GHz and $\alpha$ to be 0.25. Although the example of using the same filter for all sub-bands has been described with some exceptions for the unshifted sub-band and the last sub-band, not all of the exceptions must be used. One or none of the exceptions may be used. For example, only the exception for the unshifted sub-band may be used, giving that sub-band a different filter. The other sub-bands, including the last sub-band, may use the same filter.

Although filters for sub-bands occupying a particular frequency range have been described with transition bands on particular sides of the sub-band as frequency shifted, the side of the transition band may depend on the frequency shifting. For example, frequency shifting in 74 may mirror the frequencies of a sub-band. A sub-band may be frequency shifted using a mixer and a frequency shifting signal with a frequency greater than or equal to the highest frequency of the sub-band. As a result, the frequencies in the frequency-shifted sub-band will be a mirror of the unshifted frequencies. As a result, the frequency location of transition bands may be mirrored to match the mirroring in the frequency conversion.

Furthermore, the filtering may be a combination of filtering both before and after frequency shifting the sub-bands back to their original frequency range in 82. For example, the sub-bands may be filtered by a low pass filter having a raised cosine response after the sub-bands have been digitized in 80. However, some sub-bands may need more filtering. The additional filtering may be performed after the sub-bands have been frequency shifted back to their original frequency in 82.

The filtered sub-bands are recombined in 78. After filtering in 76, the frequency components in the overlapping frequency range of the sub-bands have been filtered to transition the source for the contribution of that frequency component to the combination from one sub-band to another.

As described above, recombining the sub-bands 78 may be done by summing the sub-bands. Since the sum of the filters used in an overlap of sub-bands is one, the recombined signal has reduced or no distortion as compared to the input signal.

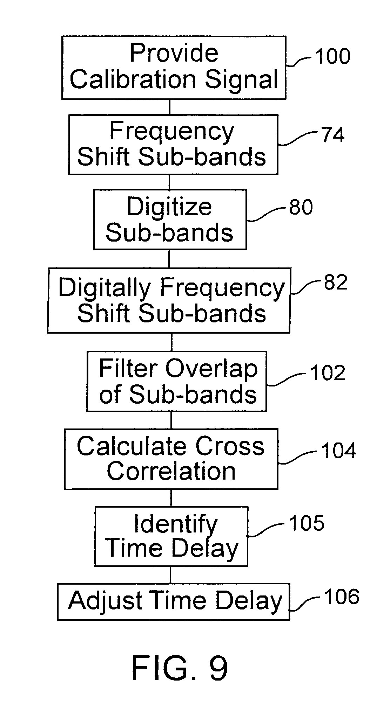

FIG. 9 is a flowchart of another embodiment of a method of reconstructing a signal including the time calibration of sub-bands. Since the sub-bands of a signal were separated and recombined, there may be some time error between the sub-bands. A time alignment calibration may be used to align the sub-bands accurately in order to accurately reconstruct the input signal. Accurate time alignment can be achieved by taking advantage of the flat pass band overlapping.

An example of a time alignment calibration includes providing a calibration signal as an input signal in 100, filtering the sub-bands in 102, calculating a cross correlation function in 104, finding the delay between sub-band by identifying the time shift where the cross correlation function peaks in 105, and adjusting a time delay between sub-bands in 106.

The calibration signal is used as the input signal to have a known signal travel the path of an input signal. The calibration signal usually is a step signal or impulse signal, both of which have wide frequency spectrums.

The sub bands are filtered in 102. For two overlapping sub-bands, the overlap portion is the desired portion.

Signals within the overlap should be time delayed by the same amount, regardless of which sub-band they are in. The filtering selects the overlapping portion from each sub-band. The cross correlation function 104 determines the relative time shift between the two sub-bands. The delay between the sub-bands is found by identifying the time shift where the cross correlation function peaks in 105. The delay is adjusted in response to the relative time shift in 106.

For any two overlapping sub-bands, a relative time shift may be calculated. Using one sub-band as a reference, all of the sub-bands can be aligned. For example, a first time delay between a first and a second sub-band is calculated. Then, a second time delay between a second and a third sub-band is calculated. Using the first sub-band as a reference sub-band, the first sub-band is not time shifted, the second sub-band is time shifted by the first time delay, and the third sub-band is time shifted by the sum of the first and second time delays.

Although particular embodiments have been described, it will be appreciated that the invention is not limited to those embodiments. Variations and modifications may be made without departing from the scope of the invention as set forth in the following claims.

**Claims**

1. An acquisition apparatus for a test and measurement instrument comprising:

    an input to receive an input signal
    a splitter to split the input signal into a plurality of split signals ;
    a plurality of frequency shifters, each frequency shifter to frequency shift a sub-band of an associated split signal to within a digitizing bandwidth;
    a plurality of digitizers, each digitizer to digitize one of the frequency shifted split signals or one of the split signals;
    a plurality of digital frequency shifters, each digital frequency shifter to frequency shift an associated digitized frequency shifted split signal into a digitized split signal;
    a plurality of filters, each filter to filter an associated digitized split signal; and
    a combiner to combine the filtered digitized split signals into a recombined signal;

    wherein each sub-band overlaps at least one other sub-band.

2. The apparatus of claim 1, wherein for a first filter and a second filter, the first filter and the second filter are operable to filter overlapping sub-bands such that a magnitude of a sum of a first frequency response of the first filter and a second frequency response of the second filter is equal to a constant over an overlap of the overlapping sub-bands.

3. The apparatus of claim 1, wherein for a first filter and a second filter, the first filter and the second filter to filter overlapping sub-bands, a magnitude of a sum of a first frequency response affecting the first sub-band including the first filter and a second frequency response affecting the second sub-band including the second filter is equal to a constant over an overlap of the overlapping sub-bands.

4. The apparatus of claim 1, wherein each filter comprises a raised cosine filter.

5. The apparatus of claim 1, wherein each frequency shifter further comprises:

    a prefilter to filter the associated split signal into a filtered split signal by attenuating frequency components of the split signal outside of the associated sub-band; and
    a mixer to mix the filtered split signal and an associated frequency shift signal into the associated frequency shifted band.

6. The apparatus of claim 1, wherein for a first filter and a second filter, the first filter and the second filter to filter overlapping sub-bands:

    each filter has a raised cosine response with identical W and $\alpha$ values except if the filter is one of a lowest sub-band and a highest sub-band;
    the first filter is offset in frequency from the second filter such that frequency responses of the first and second filters cross at a crossing frequency at which the magnitudes of the first and second filters are 0.5; and
    the crossing frequency is substantially at the center of the overlap of the sub-bands.

7. The apparatus of claim 1, wherein each filter further comprises:

a passband extending over a frequency range of the associated sub-band where there is no overlap with another sub-band;

at least one transition band between the passband and a passband of another filter, the transition band having a raised cosine response; and

at least one attenuation band over an attenuation frequency range outside of the passband and any transition band.

8. The apparatus of claim 1, further comprising a plurality of time shifters to time shift the digitized split signals.

9. An acquisition apparatus for a test and measurement instrument comprising:

a plurality of filters, each filter to filter one of a plurality of sub-band signals of an input signal, each sub-band signal having a sub-band of the input signal, a passband of at least one of the sub-bands overlapping a passband of an adjacent sub-band;

a combiner to combine the filtered sub-bands into a recombined signal.

10. The apparatus of claim 9, wherein for a first filter and a second filter, the first filter and the second filter to filter overlapping sub-bands, a magnitude of a sum of a first frequency response of the first filter and a second frequency response of the second filter is equal to a constant over an overlap of the overlapping sub-bands.

11. The apparatus of claim 9, wherein each filter is a raised cosine filter.

12. The apparatus of claim 9, wherein each filter further comprises:

a passband extending over a frequency range of the associated sub-band where there is no overlap with another sub-band;

at least one transition band between the passband and a passband of another filter, the transition band having a raised cosine response; and

at least one attenuation band over an attenuation frequency range outside of the passband and any transition band.

13. A method of reconstructing a signal comprising:

receiving an input signal having a plurality of sub-bands;
frequency shifting at least one sub-band;
digitizing the sub-bands;
digitally frequency shifting the at least one frequency shifted sub-band to the sub-band's original frequency range;
filtering the sub-bands; and
recombining the sub-bands;

wherein a pass-band of at least one of the sub-bands overlaps a pass-band of another sub-band.

14. The method of claim 13, wherein filtering the sub-bands further comprises filtering each sub-band with a filter, for a first and a second filter, the first filter and the second filter to filter overlapping sub-bands, a magnitude of a sum of a first frequency response of the first filter and a second frequency response of the second filter is equal to a constant over an overlap of the overlapping sub-bands.

15. The method of claim 13, wherein the filtering of any sub-band occurs before the sub-band is digitally frequency shifted.

16. The method of claim 13, wherein the filtering of any sub-band that is frequency shifted occurs after the sub-band is digitally frequency shifted.

17. The method of claim 13, wherein filtering the sub-bands further comprises filtering the sub-bands with raised cosine filters.

18. The method of claim 13, wherein filtering the sub-bands further comprises filtering each sub-band with a filter having:

a passband extending over a frequency range of the associated sub-band where there is no overlap with another sub-band;
at least one transition band between the passband and a passband of another filter, the transition band having a raised cosine response; and
at least one attenuation band over an attenuation frequency range outside of the passband and any transition band.

**19.** The method of claim 13, further comprising:

providing a calibration signal as the input signal; and
for a first and a second sub-band, the first and second sub-bands overlapping:

filtering the first sub-band to pass only the overlapping portion;
filtering the second sub-band to pass only the overlapping portion;
calculating a cross correlation function between the filtered first sub-band and the filtered second sub-band;
identifying a time offset between the filtered first sub-band and the filtered second sub-band in response to a peak of the cross correlation function; and
adjusting the time offset between the first and second sub-bands.

**20.** The method of claim 19, wherein providing the calibration signal as the input signal further comprises providing one selected from the group consisting of an impulse signal and a step signal as the calibration signal.

**21.** The method of claim 13, further comprising selecting at least one frequency for the frequency shifting the at least one sub-band, wherein the at least one frequency is offset relative to a midpoint of an overlap of an associated sub-band with another sub-band.

FIG. 1

FIG. 2

EP 1 726 966 A1

FIG. 3

FIG. 4

FIG. 5

FIG. 6

```
┌──────────────┐
│   Receive    │──70
│ Input Signal │
└──────────────┘
        │
┌──────────────┐
│  Frequency   │
│Shift Sub-bands│──74
└──────────────┘
        │
┌──────────────┐
│  Digitize    │──80
│  Sub-bands   │
└──────────────┘
        │
┌──────────────┐
│  Digitally   │
│  Frequency   │──82
│Shift Sub-bands│
└──────────────┘
        │
┌──────────────┐
│   Filter     │──76
│  Sub-bands   │
└──────────────┘
        │
┌──────────────┐
│  Recombine   │──78
│  Sub-bands   │
└──────────────┘
```

FIG. 7

```
┌──────────────┐
│   Receive    │──70
│ Input Signal │
└──────────────┘
        │
┌──────────────┐
│  Frequency   │
│Shift Sub-bands│──74
└──────────────┘
        │
┌──────────────┐
│  Digitize    │──80
│  Sub-bands   │
└──────────────┘
        │
┌──────────────┐
│   Filter     │──76
│  Sub-bands   │
└──────────────┘
        │
┌──────────────┐
│  Digitally   │
│  Frequency   │──82
│Shift Sub-bands│
└──────────────┘
        │
┌──────────────┐
│  Recombine   │──78
│  Sub-bands   │
└──────────────┘
```

FIG. 8

```
┌─────────────────────┐
│       Provide       │ ╱─100
│  Calibration Signal │
└─────────────────────┘
           │
┌─────────────────────┐
│      Frequency      │ ╱─74
│  Shift Sub-bands    │
└─────────────────────┘
           │
┌─────────────────────┐
│      Digitize       │ ╱─80
│     Sub-bands       │
└─────────────────────┘
           │
┌─────────────────────┐
│ Digitally Frequency │ ╱─82
│   Shift Sub-bands   │
└─────────────────────┘
           │
┌─────────────────────┐
│   Filter Overlap    │ ╱─102
│   of Sub-bands      │
└─────────────────────┘
           │
┌─────────────────────┐
│  Calculate Cross    │ ╱─104
│    Correlation      │
└─────────────────────┘
           │
┌─────────────────────┐
│      Identify       │ ╱─105
│    Time Delay       │
└─────────────────────┘
           │
┌─────────────────────┐
│  Adjust Time Delay  │ ╱─106
└─────────────────────┘
```

# FIG. 9

## EUROPEAN SEARCH REPORT

**European Patent Office**

| Application Number |
| --- |
| EP 06 25 2682 |

### DOCUMENTS CONSIDERED TO BE RELEVANT

| Category | Citation of document with indication, where appropriate, of relevant passages | Relevant to claim | CLASSIFICATION OF THE APPLICATION (IPC) |
| --- | --- | --- | --- |
| D,X | WO 2004/038432 A (LECROY CORPORATION) 6 May 2004 (2004-05-06) * page 5, line 10 - page 7, line 33 * * page 8, line 16 - page 9, line 9 * * page 9, line 19 - line 30; figures 1-3 * ----- | 1-21 | INV. G01R13/34 G01R13/02 H03M1/12 |
| X | US 4 720 674 A (TAKEUCHI ET AL) 19 January 1988 (1988-01-19) * figure 1 * ----- | 9-12 | |
| | | | **TECHNICAL FIELDS SEARCHED (IPC)** G01R H03M |

The present search report has been drawn up for all claims

| Place of search | Date of completion of the search | Examiner |
| --- | --- | --- |
| Berlin | 28 August 2006 | Binger, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
                   
& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 06 25 2682

This annex lists the patent family members relating to the patent documents cited in the above-mentioned European search report.
The members are as contained in the European Patent Office EDP file on
The European Patent Office is in no way liable for these particulars which are merely given for the purpose of information.

28-08-2006

| Patent document cited in search report | | Publication date | Patent family member(s) | | Publication date |
|---|---|---|---|---|---|
| WO 2004038432 | A | 06-05-2004 | AU | 2003291653 A1 | 13-05-2004 |
| | | | CN | 1723621 A | 18-01-2006 |
| | | | EP | 1554807 A2 | 20-07-2005 |
| | | | JP | 2006504100 T | 02-02-2006 |
| US 4720674 | A | 19-01-1988 | DE | 217953 T1 | 03-09-1987 |

EPO FORM P0459

For more details about this annex : see Official Journal of the European Patent Office, No. 12/82

**REFERENCES CITED IN THE DESCRIPTION**

**Patent documents cited in the description**

- US 68456505 P
- US 20040128076 A, Pupalaikis